(19) Europäisches Patentamt / European Patent Office / Office européen des brevets

(11) **EP 2 887 622 B1**

(12) **FASCICULE DE BREVET EUROPEEN**

(45) Date de publication et mention de la délivrance du brevet:
**09.01.2019 Bulletin 2019/02**

(51) Int Cl.:
*H03M 7/30* *(2006.01)*    *H04L 29/12* *(2006.01)*

(21) Numéro de dépôt: **14198880.8**

(22) Date de dépôt: **18.12.2014**

(54) **Procédé d'encodage et procédé de décodage d'une liste d'identifiants, produits programme d'ordinateur associés, émetteur et récepteur mettant en oeuvre lesdits procédés**

Kodier- und Dekodierverfahren einer Liste von Identifikatoren, entsprechende Computerprogrammprodukte sowie entsprechende Sender und Empfänger, die diese Verfahren umsetzen

Method for encoding and method for decoding a list of identifiers, related computer program products, transmitter and receiver implementing said methods

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.12.2013 FR 1302989**

(43) Date de publication de la demande:
**24.06.2015 Bulletin 2015/26**

(73) Titulaire: **Thales**
**92200 Neuilly Sur Seine (FR)**

(72) Inventeur: **Sanvoisin, Patrick**
**92622 Gennevilliers Cedex (FR)**

(74) Mandataire: **Lavoix**
**2, place d'Estienne d'Orves**
**75441 Paris Cedex 09 (FR)**

(56) Documents cités:
**EP-A1- 1 093 250    WO-A1-2008/063012**
**WO-A2-02/46938**

• **Donald E Knuth: "Section 7.2.1.3 Generating all combinations", The Art Of Computer Programming, 29 août 2003 (2003-08-29), XP055139879, Extrait de l'Internet: URL:http://www-cs-faculty.stanford.edu/~uno/taocp.html [extrait le 2014-09-12]**

**Description**

La présente invention concerne un procédé d'encodage d'une liste d'identifiants utilisable dans un réseau informatique, le réseau informatique comportant au moins un émetteur et au moins un récepteur,

le ou chaque émetteur et le ou chaque récepteur comportant une même liste globale d'identifiants différents, chaque identifiant présentant une caractéristique technique,

le ou chaque émetteur étant apte à émettre un paquet de données à destination d'une ou plusieurs récepteurs différents, chaque paquet de données comportant au moins un code correspondant à une liste d'identifiants codée, dans laquelle chaque identifiant n'est présent au plus qu'une fois.

Dans le domaine de la télécommunication ou de l'informatique, il est souvent nécessaire de transmettre une liste d'identifiants tous différents appartenant à un ensemble plus grand d'identifiants connus.

Une telle transmission est par exemple nécessaire, lorsqu'un émetteur transmet un paquet de données commun pour une pluralité de récepteurs. Dans ce cas, la liste d'identifiants de ces récepteurs est généralement incluse en entête du paquet de donnés à transmettre et cet entête est transmis ensuite à l'ensemble de récepteurs du réseau informatique.

A la réception de cet entête, chaque récepteur en extrait la liste d'identifiants et si son identifiant est dans la liste, ce récepteur continue à recevoir le paquet de données entièrement. Dans le cas contraire, le récepteur ignore la réception du paquet ou le transmet à un autre récepteur sans l'avoir lu.

Dans des réseaux informatiques de grandes dimensions, l'identifiant d'un récepteur est représenté généralement par un nombre de longueur importante ou par une combinaison complexe de chiffres et de lettres ou d'autres symboles. La taille de l'entête d'un paquet de données comportant une liste de tels identifiants dévient donc très importante et dépasse parfois la taille du reste du paquet. Ceci conduit notamment à une surcharge du réseau informatique.

Différents techniques de transmission permettant de diminuer la taille d'une telle liste d'identifiants existent dans l'état de la technique.

On connait par exemple WO 02/46938 A2 qui décrit un procédé d'encodage d'une liste d'identifiants en utilisant des masques.

On connait également le document Donald E Knuth « Section 7.2.1.3 Generating all combinations » qui décrit des méthodes d'encodage d'une liste d'éléments ordonnée selon un ordre lexicographique.

Par ailleurs, il est commun d'encoder une liste d'identifiants tous différents appartenant à un ensemble plus grand d'identifiants connus.

La théorie de codage montre par ailleurs que le nombre minimal de bits nécessitant pour transmettre une liste d'identifiants appartenant à un ensemble plus grand d'identifiants est égal à l'expression suivante :

$$N_B = \left\lceil \log_2 C_N^P \right\rceil$$

avec

$\ulcorner . \urcorner$ désignant la partie entière par excès,
$N_B$ désignant le nombre de bits,
$P$ désignant le nombre de destinataires,
$N$ désignant le nombre total de récepteurs, et

$C_N^P$ désignant le nombre de sous-ensembles de cardinal P, dans un ensemble de cardinal $N$.

Un encodage optimal est un encodage permettant d'obtenir une longueur de code de cette taille. Un encodage optimal donne donc un code de taille théorique minimale pour une liste d'identifiants appartenant à un ensemble plus grand d'identifiants. Cette taille théorique minimale permet en particulier de transmettre efficacement une liste d'identifiants même dans un réseau informatique de grande dimension.

Toutefois, cette solution n'est pas complètement satisfaisante.

Notamment, l'utilisation d'un encodage optimal nécessite généralement de maintenir dans la mémoire de l'émetteur et de chaque récepteur une table de codage comportant toutes les correspondances entre les codes et les identifiants. La taille de cette table est très importante même pour un réseau informatique de dimension raisonnable.

La présente invention a pour but de proposer un procédé d'encodage optimal sans nécessiter de maintenir une table de codage dans la mémoire.

A cet effet, l'invention a pour objet un procédé d'encodage conformément à la revendication 1.

Suivant d'autres aspects avantageux de l'invention, le procédé d'encodage d'une liste d'identifiants comprend une caractéristique de la revendication 2 ou 3.

L'invention a également pour objet un produit programme d'ordinateur comportant des instructions logicielles qui, lorsqu'elles sont mises en oeuvre par un calculateur, mettent en oeuvre le procédé d'encodage tel que défini ci-dessus.

L'invention a également pour objet un émetteur pour un réseau informatique conformément à la revendication 5.

L'invention a également pour objet un procédé de décodage conformément à la revendication 6.

L'invention a également pour objet un produit programme d'ordinateur comportant des instructions logicielles qui, lorsqu'elles sont mises en oeuvre par un calculateur, mettent en oeuvre le procédé de décodage tel que défini ci-dessus.

L'invention a également pour objet un récepteur pour un réseau informatique conformément à la revendication 8.

Ces caractéristiques et avantages de l'invention apparaîtront à la lecture de la description qui va suivre, donnée uniquement à titre d'exemple non limitatif, et faite en référence aux dessins annexés, sur lesquels :

- la figure 1 est une vue schématique d'un réseau informatique comportant un émetteur selon l'invention et une pluralité de récepteurs selon l'invention ;
- la figure 2 est une vue schématique de l'émetteur de la figure 1 ;
- la figure 3 est une vue schématique d'un récepteur de la figure 1 ;
- la figure 4 est une vue schématique d'un paquet de données apte à être produit par l'émetteur de la figure 2 à être transmis au récepteur de la figure 3 ;
- la figure 5 est une vue schématique d'une table de codage selon l'invention comportant 3 colonnes et 35 lignes ;
- la figure 6 est un organigramme d'un procédé d'encodage selon l'invention, mis en oeuvre par un logiciel d'encodage faisant partie de l'émetteur de la figure 2 ; et
- la figure 7 est un organigramme d'un procédé de décodage selon l'invention mis en oeuvre par un logiciel de décodage faisant partie du récepteur de la figure 3.

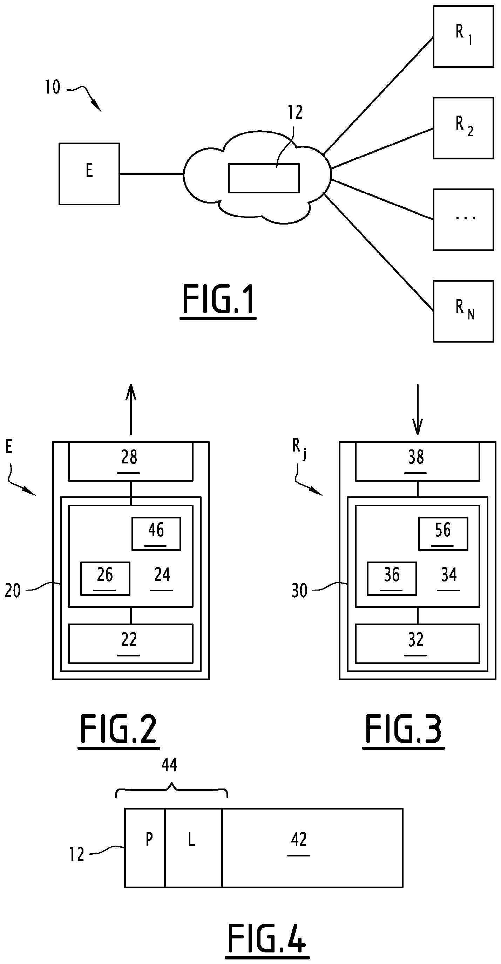

Un réseau 10 informatique est illustré sur la figure 1. Le réseau informatique 10 comporte un émetteur E selon l'invention et une pluralité de récepteurs $R_1$ à $R_N$ selon l'invention, le nombre total de récepteurs $R_1$ à $R_N$ étant égal à $N$.

En variante, le réseau informatique 10 comporte plusieurs émetteurs E.

Le ou chaque émetteur E est par exemple par un équipement électronique tel qu'un ordinateur, un téléphone portable ou tout autre moyen apte à envoyer un paquet 12 de données numériques à destination d'un ou plusieurs récepteurs $R_1$ à $R_N$. Dans la suite de la description, on désignera par $P$ le nombre de destinataires correspondant au nombre des récepteurs $R_1$ à $R_N$ auxquels le paquet 12 est destiné.

L'architecture de l'émetteur E est illustrée sur la figure 2. Ainsi, comme illustré sur cette figure 2, le récepteur E comporte une unité 20 de traitement de données.

L'unité de traitement de données 20 est formée par exemple d'un processeur 22 et d'une mémoire 24 associée à ce processeur 22.

Le processeur 22 est apte à exécuter une pluralité de logiciels que la mémoire 24 est apte à stocker.

Ainsi, par exemple, la mémoire 24 est apte à stocker un logiciel 26 de génération de données. Un tel logiciel 26 est apte par exemple à générer des données numériques à destination de $P$ récepteurs $R_1$ à $R_N$.

L'émetteur E comporte en outre une unité 28 d'émission reliée à l'unité de traitement de données 20. L'unité d'émission 28 est apte à former un paquet de données 12 correspondant aux données numériques générées par le logiciel 26 et à émettre ce paquet 12 dans le réseau informatique 10.

Chaque récepteur $R_1$ à $R_N$ est par exemple un équipement électronique tel qu'un ordinateur, un téléphone portable ou tout autre moyen apte à recevoir un paquet de données 12 en provenance du ou de chaque émetteur E.

L'architecture d'un récepteur $R_j$ est illustrée sur la figure 3. Ainsi, comme illustré sur cette figure 3, le récepteur $R_j$ comporte une unité 30 de traitement de données.

L'unité 30 est formée par exemple d'un processeur 32 et d'une mémoire 34 associée à ce processeur 32.

Le processeur 32 est apte à exécuter une pluralité de logiciels que la mémoire 34 est apte à stocker.

Ainsi, par exemple, la mémoire 34 est apte à stocker un logiciel 36 de consommation de données.

Le récepteur $R_j$ comporte en outre une unité 38 de réception reliée à l'unité de traitement de données 30. L'unité de réception 38 est apte à recevoir chaque paquet de données 12 émis dans le réseau informatique 10 par le ou chaque émetteur E et de transmettre les données numériques correspondantes vers le logiciel 36 qui est alors apte à consommer ces données 12 reçues.

L'architecture de tous les autres récepteurs $R_1$ à $R_N$ est semblable à celle du récepteur $R_j$.

Chaque récepteur $R_1$ à $R_N$ comporte un identifiant $Id_k$ unique dans le réseau informatique 10, les identifiants $d_k$ sont tous différents. Cet identifiant $Id_k$ permet de distinguer de manière unique et certaine chaque récepteur $R_1$ à $R_N$.

Chaque identifiant $Id_k$ est par exemple un nombre entier positif.

En variante, chaque identifiant $Id_k$ est une succession de chiffres et/ou de lettres ou d'autres symboles acceptables par le réseau informatique 10.

Dans les deux cas, chaque identifiant $Id_k$ est apte à être associé à un nombre entier $k$ compris entre 1 et $N,$ le nombre $k$ étant différent pour des identifiants $Id_k$ différents.

Ainsi, par exemple, le nombre $k$ est le numéro de l'identifiant $Id_k$ dans une liste ordonnée comportant l'ensemble des identifiants $Id_k$ du réseau informatique 10.

Une telle association est apte à être connue par le ou chaque émetteur E et l'ensemble des récepteurs $R_1$ à $R_N$ avant toute transmission.

En variante, cette association est apte à être définie dans une phase de construction du réseau 10.

La structure du paquet de données 12 est illustrée en détail sur la figure 4.

Ainsi, comme illustré sur cette figure 4, le paquet de données 12 est formé d'un message applicatif 42 et d'un entête 44. Un tel paquet de données 12 est apte à être généré par l'unité d'émission 28 du ou de chaque émetteur E et être reçu par l'unité de réception 38 de chaque récepteur $R_1$ à $R_N$.

Le message applicatif 42 comprend les données numériques générées par le logiciel de génération de données 26 et destinées à un ou plusieurs récepteurs $R_1$ à $R_N$.

L'entête 44 comprend toute information auxiliaire permettant de transmettre le paquet 12 au destinataire correspondant via le réseau informatique 10.

Ainsi, dans l'exemple de réalisation illustré sur la figure 4, l'entête 44 inclut le nombre P de destinataires et une liste codée $L$ d'identifiants de récepteurs $R_1$ à $R_N$ auxquels ce paquet 12 est destiné.

Une telle liste d'identifiants $L$ permet par exemple à l'émetteur E d'émettre le paquet 12 dans le réseau informatique 10 sans précision explicite de cheminement.

Chaque récepteur $R_1$ à $R_N$ est donc apte à recevoir au moins l'entête 44 de chaque paquet 12 émis. Ainsi, l'unité de réception 38 du récepteur correspondant est apte à lire la liste d'identifiants $L$ et, si son identifiant $Id_k$ est dans la liste, à continuer la réception du paquet 12. Dans le cas contraire, le récepteur est apte à ignorer la réception du paquet 12 ou à le transmettre vers un autre récepteur $R_1$ à $R_N$.

La liste d'identifiants $L$ est encodée par un code C afin de minimiser sa taille. La taille de la liste d'identifiants $L$ est mesurée en nombre $N_B$ de bits que cette liste occupe dans l'entête 44.

A cet effet, la mémoire 24 de l'émetteur E est apte à stocker en outre un logiciel 46 d'encodage permettant d'encoder la liste d'identifiants $L$ pour chaque paquet 12 émis par cet émetteur E.

En variante, un tel encodage est assuré par un module d'encodage indépendant faisant partie du ou de chaque émetteur E.

De manière analogue, la mémoire 34 de chaque récepteur $R_1$ à $R_N$ est apte à stocker en outre un logiciel 56 de décodage permettant de décoder le code C de chaque paquet 12 reçu par l'unité de réception 38 de ce récepteur $R_1$ à $R_N$ pour obtenir la liste d'identifiants $L$ correspondante.

En variante, un tel décodage est assuré par un module de décodage indépendant faisant partie de chaque récepteur $R_1$ à $R_N$.

Le fonctionnement du logiciel d'encodage 46 de l'émetteur E va désormais être expliqué.

Le logiciel d'encodage 46 est mis en oeuvre par un procédé 100 d'encodage d'une liste d'identifiants selon l'invention.

Ce procédé d'encodage est basé sur une table Tp de codage pour chaque nombre $P$ d'identifiants de la liste d'identifiants $L$.

Ainsi, pour un paquet de données 12 considéré, une telle table de codage Tp est formée par une pluralité de colonnes au nombre de $P$ et une pluralité de lignes au nombre égal au nombre de sous-ensembles de cardinal $P$ dans un ensemble de cardinal $N$, c'est-à-dire :

$$[Tp] = C_N^P \times P$$

où $[Tp]$ désigne les dimensions de la table Tp.

Chaque ligne de la table Tp est numéroté de 0 à $C_N^P - 1$ et est formée par une liste d'identifiants $L$ comportant $P$ identifiants $Id_k$ différents. Chaque identifiant $Id_k$ correspond ainsi à une colonne.

Dans la suite de la description, on désignera par $LG$ une liste globale ordonnée d'identifiants comportant l'ensemble des identifiants $Id_k$ du réseau informatique 10 triés par l'ordre décroissant du nombre $k$ associé à chaque identifiant $Id_k$.

La table de codage Tp est construite de façon unique pour $N$ récepteurs et $P$ destinataires d'après une loi décrite ci-dessous.

Cette loi utilise certaines propriétés du triangle de Pascal. En particulier, la relation suivante :

$$C_N^P = \sum_{q=P-1}^{N-1} C_q^{P-1}.$$

permet de construire la première colonne de la table Tp avec N - $P$ + 1 d'identifiants différents.

Plus particulièrement, les $C_{N-1}^{P-1}$ premières lignes de la première colonne de la table Tp sont remplies par le premier identifiant $Id_k$ de la liste globale d'identifiants $LG$.

Les $C_{N-2}^{P-1}$ lignes suivantes de la première colonne sont remplies par le deuxième identifiant $Id_k$ de la liste globale d'identifiants $LG$.

Finalement, la dernière ligne de la première colonne correspondant au nombre $C_{P-1}^{P-1}$ est remplie par l'identifiant $Id_k$ ayant la position N - $P$ + 1 dans liste globale d'identifiants $LG$.

Ainsi, toutes les $C_N^P$ lignes de la table sont remplies avec N - $P$ + 1 d'identifiants différents.

La deuxième colonne de la table Tp est construite analogiquement en retirant le premier identifiant $Id_k$ de la liste globale d'identifiants $LG$ et en décrémentant d'un les nombres $N$ et $P$.

Les autres colonnes sont obtenues en appliquant la même règle récursive.

En utilisant l'analyse combinatoire, il est possible de démontrer que la table de codage Tp ainsi construite comporte *toutes* les listes $L$ différentes possibles comportant $P$ identifiants différents parmi $N$ identifiants du réseau 10.

Ainsi, le numéro de chaque ligne détermine de façon unique la liste d'identifiants $L$ correspondante. Le logiciel d'encodage 46 associe alors un code $C$ égal au numéro de la ligne à chaque liste d'identifiants $L$ comportant $P$ identifiants.

En conséquence, le nombre de bits $N_B$ nécessaires pour transmettre ce code $C$ dans l'entête 44 est égal à la partie entière par excès du logarithme de base deux du nombre de sous-ensembles de cardinal égal au nombre de destinataires $P$, dans un ensemble de cardinal égal au nombre total de récepteurs $N$, c'est-à-dire,

$$N_B = \left\lceil \log_2 C_N^P \right\rceil.$$

Ceci signifie notamment que l'encodage par la table de codage Tp est un encodage optimal et qu'il n'existe pas d'autres encodages permettant d'obtenir un code $C$ de taille inférieure.

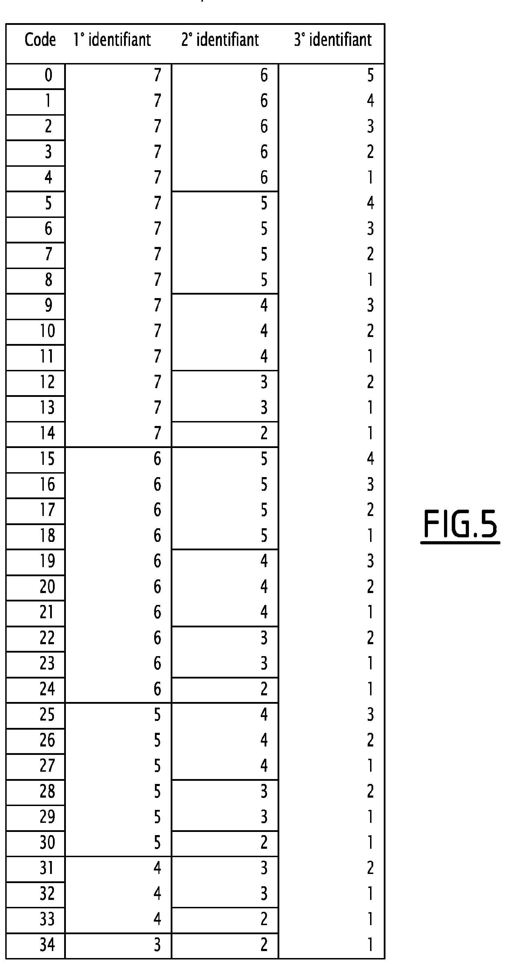

Un exemple d'une table de codage Tp pour $N$ = 7 et $P$ = 3 est représenté sur la figure 5. Dans cet exemple, chaque identifiant $Id_k$ correspond à un nombre enter allant de 1 à 7. Chaque nombre $k$ associé est simplement égal à l'identifiant $Id_k$ correspondant.

Ainsi, dans l'exemple de la figure 5, le code $C$ pour une liste d'identifiants comportant les identifiants « 5 », « 3 » et « 1 » est égal à « 29 ». Le nombre de bits $N_B$ nécessaires pour transmettre ce code $C$ est égal à 6 bits.

Le procédé d'encodage 100 permet d'obtenir un code $C$ d'une liste d'identifiants L comportant $P$ identifiants correspondant au numéro de la ligne comportant cette liste $L$ dans la table de codage Tp correspondante, ceci étant réalisé sans construction explicite de la table Tp et sans nécessité de la maintenir dans la mémoire.

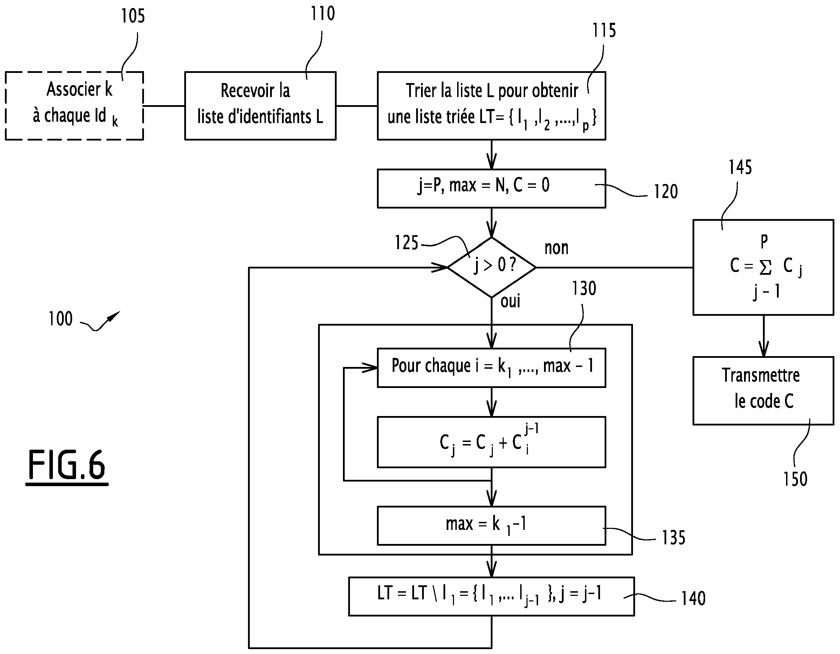

L'organigramme du procédé d'encodage 100 mis en oeuvre par l'unité de traitement 30, est représenté sur la figure 6. Il est mise en oeuvre, à la volée, pendant chaque transmission d'un paquet 12.

Lors d'une étape préliminaire 105, le logiciel d'encodage 46 associe à chaque identifiant $Id_k$ un nombre $k$ entier compris entre un et le nombre total de récepteurs $N$, le nombre $k$ étant différent pour des identifiants $Id_k$ différents.

Cette étape 105 est effectuée par exemple dans la phase de construction du réseau informatique 10. Les résultats de cette association sont ensuite transmis à l'ensemble des récepteur $R_1$ à $R_N$ du réseau informatique 10.

Lors de l'étape 110, le logiciel d'encodage 46 reçoit du logiciel de génération de données 26, une liste d'identifiants $L$ comportant P indentifiants $Id_k$.

Lors de l'étape 115, le logiciel d'encodage 46 trie la liste d'identifiants $L$ par ordre décroissant du nombre $k$ associé à chaque identifiant $Id_k$ pour obtenir une liste $LT$ triée d'identifiants.

Cette liste triée d'identifiants $LT$ est donc ordonnée et a une forme suivante :

$$LT = \{l_1, l_2, \ldots, l_P\}$$

où chaque $l_j$ correspond à un identifiant $Id_k$ de la liste d'identifiants $L$ ordonné selon l'ordre décroissant du nombre $k$.

Lors de l'étape 120, le logiciel d'encodage 46 définit une première variable $j$ entière égale au nombre de destinataires $P$, une valeur maximale intermédiaire *max* égale au nombre total de récepteurs $N$, c'est-à-dire :

$$j = P, max = N.$$

Dans la même étape, le logiciel d'encodage 46 initialise le code C par zéro.

Tant que la première variable $j$ est supérieure à zéro lors de l'étape 125, le logiciel d'encodage 46 passe à l'étape 130.

Lors de l'étape 130, le logiciel d'encodage 46 varie une deuxième variable $i$ entière entre le nombre $k_1$ associé au premier identifiant $l_1$ de la liste triée d'identifiants $LT$ et la valeur maximale intermédiaire $max$ décrémentée d'un.

Dans cette étape 130, le logiciel d'encodage 46 pour chaque valeur de la deuxième variable $i$, calcule le nombre de sous-ensembles de cardinal égal à la première variable $j$ décrémentée d'un, dans un ensemble de cardinal égal à la deuxième variable $i$.

Le logiciel d'encodage 46 calcule par ailleurs un code élémentaire $C_j$ correspondant au premier identifiant $l_1$ de la liste triée d'identifiants $LT$ comme la somme des nombres de sous-ensembles, c'est-à-dire :

$$C_j = \sum_{i=k_1}^{max-1} C_i^{j-1}.$$

Lors de l'étape 135, le logiciel d'encodage 46 met la valeur maximale intermédiaire $max$ égale au nombre $k_1$ associé au premier identifiant $l_1$ décrémentée d'un, c'est-à-dire :

$$max = k_1 - 1.$$

Lors de l'étape 140, le logiciel d'encodage 46 enlève l'identifiant $l_1$ de la liste triée d'identifiants $LT$ et décrémente d'un la première variable $j$, c'est-à-dire :

$$LT' = LT \backslash l_1 = \{l_2, .. l_j\}, \qquad j' = j - 1.$$

Le logiciel d'encodage 46 change les noms de variables dans la liste $LT'$ sans permutation de celles-ci, de façon à obtenir une liste suivante :

$$LT' = \{l_1, .. l_{j-1}\}.$$

Le logiciel d'encodage 46 actualise la liste $LT$ et la variable $j'$ comme ceci :

$$LT = LT', \quad j = j'.$$

Puis, le logiciel d'encodage 46 retourne à l'étape 125.

Si lors de l'étape 125, la première variable $j$ est égale à zéro, le logiciel d'encodage 46 passe à l'étape 145.

Autrement dit, lors des étapes précédentes, tant que la première variable $j$ est supérieure à zéro, le logiciel d'encodage code le premier identifiant $l_1$ de la liste triée d'identifiants $LT$ par un code élémentaire $C_j$ correspondant au nombre de sous-ensembles de la liste globale $LG$ d'identifiants de cardinal égal au nombre d'identifiants $Id_k$ de la liste triée d'identifiants $LT$, chaque sous-ensemble étant trié par ordre décroissant du nombre $k$ associé à chaque identifiant $Id_k$ et comportant dans la première position un identifiant $Id_k$ avec un nombre $k$ associé supérieur au nombre $k$ associé au premier identifiant $l_1$ de la liste triée d'identifiants $LT$, enlève cet identifiant $l_1$ de la liste triée d'identifiants $LT$ et décrémenter d'un la première variable $j$.

Lors de l'étape 145, le logiciel d'encodage 46 calcule le code C en faisant la somme de tous les codes élémentaires $C_j$ obtenus, c'est-à-dire :

$$C = \sum_{j=1}^{P} C_j.$$

Lors de l'étape 150, le logiciel d'encodage 46 transmet le code C obtenu à l'unité d'émission 28.

Le fonctionnement du logiciel de décodage 56 mis en oeuvre par l'unité de traitement 30 de chaque récepteur $R_1$ à $R_N$, mis en oeuvre par un procédé 200 de décodage d'une liste d'identifiants selon l'invention va désormais être expliqué.

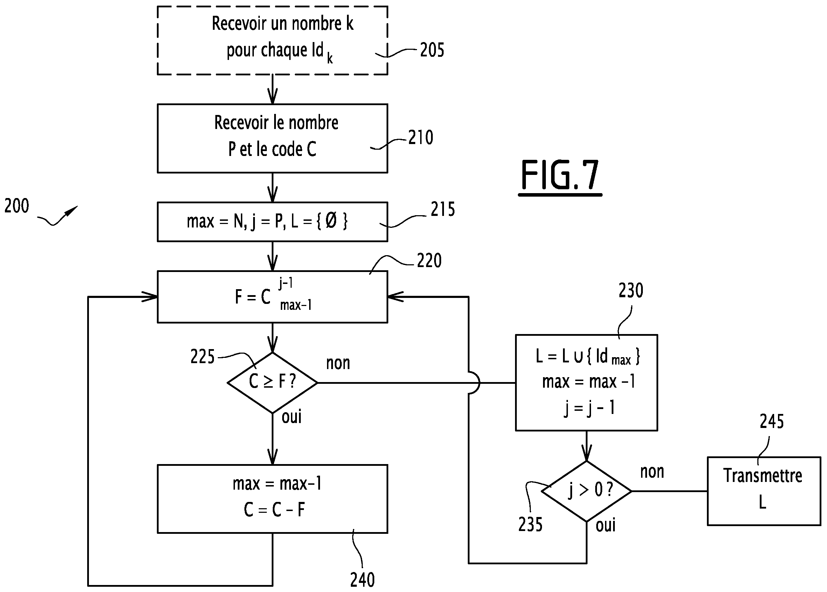

L'organigramme du procédé de décodage 200 est représenté sur la figure 7. Ce procédé 200 est mise en oeuvre à chaque réception.

Lors d'une étape 205 préliminaire, le logiciel de décodage 56 reçoit une liste comportant pour chaque identifiant $Id_k$ un nombre k associé à cet identifiant. Cette étape 205 est effectuée par exemple dans la phase de construction du réseau informatique 10.

Lors de l'étape 210, le logiciel de décodage 56 reçoit le nombre d'identifiants P et le code C de la part de l'unité de réception 38.

Lors de l'étape 215, le logiciel de décodage 56 définit une valeur maximale intermédiaire *max* égale au nombre total de récepteurs N et une première variable j entière égale au nombre de destinataires P, c'est-à-dire :

$$max = N, \quad j = P.$$

Le logiciel de décodage 56 initialise en outre une liste d'identifiants L par une liste vide, c'est-à-dire :

$$L = \{\emptyset\}.$$

Lors de l'étape 220, le logiciel de décodage 56 calcule le nombre F de sous-ensembles de cardinal égal à la première variable j décrémentée d'un, dans un ensemble de cardinal égal à la valeur maximale intermédiaire *max* décrémentée d'un, c'est-à-dire :

$$F = C_{max-1}^{j-1}.$$

Si lors de l'étape 225 la valeur du code C est inférieure audit nombre de sous-ensembles, lors de l'étape 230 le logiciel de décodage 56 ajoute dans la liste d'identifiants L l'identifiant $Id_k$ avec un nombre k associé égal à la valeur maximale intermédiaire *max,* décrémente la valeur maximale intermédiaire *max* et la première variable j d'un, c'est-à-dire :

$$L = L \cup \{Id_{max}\}, \qquad max' = max - 1, \qquad j' = j - 1$$
$$max = max', \quad j = j'.$$

Si lors de l'étape 235, la première variable j est supérieure à zéro, le logiciel de décodage 56 retourne à l'étape 225.

Si lors de l'étape 225 la valeur du code C est supérieure ou égale audit nombre de sous-ensembles, lors de l'étape 240 le logiciel de décodage 56 décrémente la valeur maximale intermédiaire *max* d'un et calcule une nouvelle valeur du code égale à la différence entre la valeur actuelle du code C et ledit nombre de sous-ensembles F, c'est-à-dire :

$$max' = max - 1, \qquad C' = C - F$$

$$max = max', \quad C = C'.$$

Le logiciel de décodage 56 retourne ensuite à l'étape 220.

Si lors de l'étape 235, la première variable j est égale à zéro, lors de l'étape 245 le logiciel de décodage 56 transmet la liste d'identifiants L obtenue à l'unité de réception 38.

Le fonctionnement du réseau informatique 10 comportant un émetteur E selon l'invention et *N* récepteurs R$_1$ à R$_N$ selon l'invention, va désormais être expliqué.

Le logiciel de génération de données 26 de l'émetteur E génère des données numériques à destination de *P* récepteurs R$_1$ à R$_N$.

Le logiciel 26 génère par ailleurs une liste d'identifiants *L* comportant les *P* identifiants *Id$_k$* des récepteurs R$_1$ à R$_N$ auxquels ces données sont destinées.

Puis, le logiciel d'encodage 46 encode cette liste d'identifiants *L* par un code *C* selon le procédé d'encodage d'une liste d'identifiants 100.

L'unité d'émission 28 forme ensuite un paquet de données 12 en y incluant un message applicatif 42 correspondant aux données numériques générées par le logiciel 26 et un entête 44. L'entête 44 comporte le nombre *P* et le code *C.*

Le paquet de données 12 est ensuite émis dans le réseau informatique 10 par l'unité d'émission.

Puis, ce paquet de données 12 ou au moins son entête 44 est reçu par l'unité de réception 38 de chaque récepteur R$_1$ à R$_N$. L'unité 38 en extrait le nombre *P* et le code *C*.

Le logiciel de décodage 56 décode ensuite le code *C* selon le procédé de décodage d'une liste d'identifiants 200, pour obtenir la liste d'identifiants *L* correspondante.

Si l'identifiant *Id$_k$* d'un récepteur R$_1$ à R$_N$ est dans la liste *L,* l'unité de réception 38 de ce récepteur R$_1$ à R$_N$ continue à recevoir le paquet de données 12 et transmet le message applicatif 42 correspondant au logiciel de consommation de données 36.

Dans le cas contraire, l'unité de réception 38 ignore la réception du paquet 12 et/ou le transmets vers un autre récepteur R$_1$ à R$_N$.

Le procédé d'encodage 100 et le procédé de décodage 200 permettent alors d'encoder et de décoder une liste d'identifiants *L* en utilisant un code *C* optimal sans nécessité de maintenir une table de codage Tp dans la mémoire du ou de chaque émetteur *E* et de l'ensemble des récepteurs R$_1$ à R$_N$. Ceci permet en particulier de réduire considérablement la taille de l'entête 44 pour chaque paquet de données à destination de *P* récepteurs R$_1$ à R$_N$.

Bien entendu, nombreux autres modes de réalisation des procédés d'encodage et de décodage sont également possible. Ainsi, par exemple, dans l'étape 115 du procédé d'encodage 100, il est possible de trier chaque liste d'identifiant *L* à transmettre par ordre croissant du nombre *k* associé. Les autres étapes du procédé d'encodage 100 et du procédé de décodage 200 sont modifiées en récurrence.

L'utilisation des procédés d'encodage 100 et de décodage 200 selon l'invention n'est pas restreinte uniquement par encodage et décodage d'une liste d'identifiants *L* dans l'entête d'un paquet de données. De manière générale, ces procédés sont applicables pour encodage et décodage d'une liste quelconque d'éléments comportant des éléments d'un ensemble connu.

**Revendications**

1. Procédé (100) d'encodage d'une liste d'identifiants (*L*) utilisable dans un réseau (10) informatique, le réseau informatique (10) comportant au moins un émetteur (E) et au moins un récepteur (R$_1$, ..., R$_N$),

   le ou chaque émetteur et le ou chaque récepteur comportant une même liste globale (*LG*) d'identifiants (*Id$_k$*) différents, chaque identifiant (*Id$_k$*) présentant une caractéristique technique,

   le ou chaque émetteur (E) étant apte à émettre un paquet (12) de données à destination d'une ou plusieurs récepteurs (R$_1$, ..., R$_N$) différents,

   chaque paquet de données (12) comportant au moins un code (*C*) correspondant à une liste d'identifiants (*L*) codée, dans laquelle chaque identifiant (*Id$_k$*) n'est présent au plus qu'une fois,

   **caractérisé en ce que** le procédé d'encodage (100) comprend les étapes suivantes :

   - associer (105) à chaque identifiant (*Id$_k$*) un nombre ordinal *(k)* compris entre un et le nombre total (*N*) d'identifiants (*Id$_k$*) dans la liste globale d'identifiants (*LG*), le nombre (*k*) étant différent pour des identifiants (*Id$_k$*) différents ;
   - ordonner selon une relation d'ordre strict prédéterminée, la liste d'identifiant (*L*) suivant le nombre ordinal (*k*) associé à chaque identifiant (*Id$_k$*) pour obtenir une liste triée (*LT*) d'identifiants ;
   - définir (120) une première variable (*j*) entière égale au nombre (*P*) d'identifiants dans la liste d'identifiants (*L*) à transmettre, initialiser une liste triée d'identifiants précédente (*LT'*) par la liste triée d'identifiants (*LT*) ;
   - coder (130, 135) le premier identifiant (*I$_1$*) de la liste triée d'identifiants précédente (*LT'*) par un code élémentaire (*C$_j$*) correspondant au nombre de sous-ensembles de la liste globale d'identifiants *(LG)* de cardinal égal au nombre d'identifiants (*Id$_k$*) de la liste triée d'identifiants précédente (*LT'*) et comportant au moins un identifiant (*Id$_k$*) dont le nombre ordinal (*k*) associé est en relation d'ordre strict prédéterminée avec le nombre ordinal (*k*)

associé au premier identifiant ($I_1$) de la liste triée d'identifiants précédente ($LT'$), enlever (140) cet identifiant ($I_1$) de la liste triée d'identifiants précédente ($LT'$) pour obtenir une liste triée d'identifiants suivante, et décrémenter d'un la première variable ($j$) ;
- coder (145) la liste d'identifiants par un code ($C$) correspondant à la somme de tous les codes élémentaires ($C_j$) obtenus.

2. Procédé (100) selon la revendication 1, **caractérisé en ce qu'**un premier nombre ordinal est en relation d'ordre strict prédéterminée avec un deuxième nombre ordinal lorsque le premier nombre ordinal est strictement supérieur au deuxième nombre ordinal.

3. Procédé (100) selon la revendication 2, **caractérisé en ce qu'**il comporte en outre les étapes suivantes :

- définir (120) une valeur maximale intermédiaire (*max*) égale au nombre total ($N$) d'identifiants ($Id_k$) dans la liste globale ($LG$) d'identifiants ;
- varier (130) une deuxième variable (i) entière entre le nombre ordinal ($k_1$) du premier identifiant ($I_1$) de la liste triée d'identifiants précédente ($LT'$) et la valeur maximale intermédiaire (*max*) décrémentée d'un ;
- pour chaque valeur de la deuxième variable (*i*), calculer le nombre de sous-ensembles de cardinal égal à la première variable (*j*) décrémentée d'un, dans un ensemble de cardinal égal à la deuxième variable (*i*) ;
- calculer (130) un code élémentaire ($C_j$) correspondant au premier identifiant ($I_1$) de la liste triée d'identifiants précédente ($LT'$) comme la somme desdits nombres de sous-ensembles, c'est-à-dire :

$$C_j = \sum_{i=k_1}^{max-1} C_i^{j-1}$$

avec

$k_1$ désignant le nombre associé audit premier identifiant,
*i* désignant ladite deuxième variable,
*max* désignant ladite valeur maximale,

$C_i^{j-1}$ désignant ledit nombre de sous-ensembles, et

$C_j$ désignant ledit code élémentaire.

- mettre (140) la valeur maximale intermédiaire (*max*) égale au nombre ($k_1$) associé au premier identifiant ($I_1$) décrémentée d'un. et
- exécuter les étapes de coder le premier identifiant de la liste triée d'identifiant précédente par un code élémentaire, d'enlever et de décrémenter tant que la première variable (j) est supérieure à zéro (125).

4. Produit programme d'ordinateur comportant des instructions logicielles qui, lorsqu'elles sont mises en oeuvre par un calculateur, mettent en oeuvre le procédé d'encodage (100) selon l'une quelconque des revendications précédentes.

5. Émetteur (E) pour un réseau (10) informatique, le réseau informatique (10) comportant au moins un récepteur ($R_1$, ..., $R_N$),
l'émetteur et le ou chaque récepteur comportant une même liste globale ($LG$) d'identifiants ($Id_k$) différents, chaque identifiant ($Id_k$) présentant une caractéristique technique,
l'émetteur (E) étant apte à émettre un paquet (12) de données à destination d'une ou plusieurs récepteurs ($R_1$, ..., $R_N$) différents,
chaque paquet de données (12) comportant au moins un code ($C$) correspondant à une liste d'identifiants ($L$) codée, dans laquelle chaque identifiant ($Id_k$) n'est présent au plus qu'une fois,
**caractérisé en ce qu'**il comporte un module (46) d'encodage apte à :

- associer (105) à chaque identifiant ($Id_k$) un nombre ordinal ($k$) compris entre un et le nombre total ($N$) d'identifiants ($Id_k$) dans la liste globale d'identifiants ($LG$), le nombre ($k$) étant différent pour des identifiants ($Id_k$) différents ;
- ordonner selon une relation d'ordre strict prédéterminée, la liste d'identifiants ($L$) suivant le nombre ordinal ($k$)

associé à chaque identifiant ($Id_k$) pour obtenir une liste triée ($LT$) d'identifiants ;
- définir (120) une première variable ($j$) entière égale au nombre ($P$) d'identifiants dans la liste d'identifiants ($L$) à transmettre, initialiser une liste triée d'identifiants précédente ($LT'$) par la liste triée d'identifiants ($LT$) ;
- coder (130, 135) le premier identifiant ($I_1$) de la liste triée d'identifiants précédente ($LT'$) par un code élémentaire ($C_j$) correspondant au nombre de sous-ensembles de la liste globale d'identifiants ($LG$) de cardinal égal au nombre d'identifiants ($Id_k$) de la liste triée d'identifiants précédente ($LT'$) et comportant au moins un identifiant ($Id_k$) dont le nombre ordinal ($k$) associé est en relation d'ordre strict prédéterminée avec le nombre ordinal ($k$) associé au premier identifiant ($I_1$) de la liste triée d'identifiants précédente ($LT'$), enlever (140) cet identifiant ($I_1$) de la liste triée d'identifiants précédente ($LT'$) pour obtenir une liste triée d'identifiants suivante, et décrémenter d'un la première variable ($j$) ;
- coder (145) la liste d'identifiants par un code ($C$) correspondant à la somme de tous les codes élémentaires ($C_j$) obtenus.

**6.** Procédé (200) de décodage d'une liste d'identifiants (iL) utilisable dans un réseau (10) informatique, le réseau informatique (10) comportant au moins un émetteur (E) et au moins un récepteur ($R_1$, ..., $R_N$),
le ou chaque émetteur et le ou chaque récepteur comportant une même liste globale ($LG$) d'identifiants ($Id_k$) différents, chaque identifiant ($Id_k$) présentant une caractéristique technique,
le ou chaque émetteur (E) étant apte à émettre un paquet (12) de données à destination d'une ou plusieurs récepteurs ($R_1$, ..., $R_N$) différents,
chaque paquet de données (12) comportant au moins un code ($C$) correspondant à une liste d'identifiants ($L$) codée, dans laquelle chaque identifiant ($Id_k$) n'est présent au plus qu'une fois,
**caractérisé en ce que** le procédé (200) comprend les étapes suivantes :

- associer (205) à chaque identifiant ($Id_k$) un nombre ordinal ($k$) compris entre un et le nombre ($N$) d'identifiants dans la liste globale d'identifiants ($LG$), le nombre ($k$) étant différent pour des identifiants ($Id_k$) différents ;
- recevoir (210) un nombre ($P$) correspondant au nombre d'identifiants ($Id_k$) dans la liste d'identifiants ($L$) à décoder, et un code ($C$) correspondant à cette liste d'identifiants ;
- définir (215) une valeur maximale intermédiaire ($max$) égale au nombre total de récepteurs ($N$) et une première variable ($j$) entière égale au nombre d'identifiants ($P$) dans la liste d'identifiants ($L$) à décoder ;
- calculer (220) le nombre ($F$) de sous-ensembles de cardinal égal à la première variable ($j$) décrémentée d'un, dans un ensemble de cardinal égal à la valeur maximale intermédiaire ($max$) décrémentée d'un ;
- si la valeur du code est inférieure audit nombre ($F$) de sous-ensembles, ajouter (230) dans la liste d'identifiants ($L$) l'identifiant ($Id_k$) avec un nombre ordinal ($k$) égal à la valeur maximale intermédiaire ($max$), décrémenter la valeur maximale intermédiaire ($max$) et la première variable ($j$) d'un ;
- si la valeur du code est supérieure ou égale audit nombre ($F$) de sous-ensembles, décrémenter (240) la valeur maximale intermédiaire ($max$) d'un et calculer une nouvelle valeur du code égale à la différence entre la valeur actuelle du code ($C$) et ledit nombre ($F$) de sous-ensembles.

**7.** Produit programme d'ordinateur comportant des instructions logicielles qui, lorsqu'elles sont mises en oeuvre par un calculateur, mettent en oeuvre le procédé (200) de décodage selon la revendication 6.

**8.** Récepteur ($R_1$, ..., $R_N$) pour un réseau (10) informatique, le réseau informatique (10) comportant au moins un émetteur (E),
le ou chaque émetteur et le récepteur comportant une même liste globale ($LG$) d'identifiants ($Id_k$) différents, chaque identifiant ($Id_k$) présentant une caractéristique technique,
le ou chaque émetteur (E) étant apte à émettre un paquet (12) de données à destination d'une ou plusieurs récepteurs ($R_1$, ..., $R_N$) différents,
chaque paquet de données (12) comportant au moins un code ($C$) correspondant à une liste d'identifiants ($L$) codée, dans laquelle chaque identifiant ($Id_k$) n'est présent au plus qu'une fois,
**caractérisé en ce qu'**il comporte un module (56) de décodage apte à :

- associer (205) à chaque identifiant ($Id_k$) un nombre ordinal ($k$) compris entre un et le nombre ($N$) d'identifiants dans la liste globale d'identifiants ($LG$), le nombre ($k$) étant différent pour des identifiants ($Id_k$) différents ;
- recevoir (210) un nombre ($P$) correspondant au nombre d'identifiants ($Id_k$) dans la liste d'identifiants ($L$) à décoder, et un code ($C$) correspondant à cette liste d'identifiants ;
- définir (215) une valeur maximale intermédiaire ($max$) égale au nombre total de récepteurs ($N$) et une première variable ($j$) entière égale au nombre d'identifiants ($P$) dans la liste d'identifiants ($L$) à décoder ;
- calculer (220) le nombre ($F$) de sous-ensembles de cardinal égal à la première variable ($j$) décrémentée d'un, dans un ensemble de cardinal égal à la valeur maximale intermédiaire (*max*) décrémentée d'un ;
- si la valeur du code est inférieure audit nombre (*F*) de sous-ensembles, ajouter (230) dans la liste d'identifiants (*L*) l'identifiant (*Id*$_k$) avec un nombre ordinal (*k*) égal à la valeur maximale intermédiaire (*max*), décrémenter la valeur maximale intermédiaire (*max*) et la première variable (*j*) d'un ;
- si la valeur du code est supérieure ou égale audit nombre (*F*) de sous-ensembles, décrémenter (240) la valeur maximale intermédiaire (*max*) d'un et calculer une nouvelle valeur du code égale à la différence entre la valeur actuelle du code (*C*) et ledit nombre (*F*) de sous-ensembles.

**Patentansprüche**

1. Verfahren (100) zum Kodieren einer Liste von Identifikatoren (L), verwendbar in einem Computernetzwerk (10), wobei das Computernetzwerk (10) mindestens einen Sender (R) und mindestens einen Empfänger ($R_1$, ..., $R_N$) aufweist,

   wobei der oder jeder Sender und der oder jeder Empfänger dieselbe globale Liste (LG) von unterschiedlichen Identifikatoren ($Id_k$) aufweisen, wobei jeder Identifikator ($Id_k$) eine technische Eigenschaft hat,

   wobei der oder jeder Sender (E) geeignet ist, ein Paket (12) mit Daten an einen oder mehrere unterschiedliche Empfänger ($R_1$, ..., $R_N$) zu senden,

   wobei jedes Paket mit Daten (12) mindestens einen Code (C) aufweist, der einer kodierten Liste von Identifikatoren (L) entspricht, in der jeder Identifikator ($Id_k$) höchstens nur einmal vorhanden ist,

   dadurch charakterisiert, dass das Verfahren zum Kodieren (100) die folgenden Schritte aufweist:

   - Zuordnen (105), zu jedem Identifikator ($Id_k$) eine Ordnungszahl (k) zwischen 1 und der Gesamtzahl (N) von Identifikatoren ($Id_k$) in der globalen Liste von Identifikatoren (LG), wobei die Zahl (k) für unterschiedliche Identifikatoren ($Id_k$) unterschiedlich ist;
   - Anordnen der Liste von Identifikatoren (L) gemäß einer vorgegebenen strengen Ordnungsrelation, wobei der Ordnungszahl (k) gefolgt wird, die jedem Identifikator ($Id_k$) zugeordnet ist, um eine sortierte Liste (LT) von Identifikatoren zu erhalten;
   - Definieren (120) einer ersten ganzzahligen Variablen (j) gleich der Anzahl (P) von Identifikatoren in der zu sendenden Liste von Identifikatoren (L), Initialisieren einer vorhergehenden sortierten Liste von Identifikatoren (LT') durch die sortierte Liste von Identifikatoren (LT);
   - Kodieren (130, 135) des ersten Identifikators ($l_1$) der vorhergehenden sortierten Liste von Identifikatoren (LT') mittels eines elementaren Codes ($C_j$) entsprechend der Anzahl von Teilmengen der globalen Liste (LG) mit einer Anzahl von Elementen, die gleich der Anzahl von Identifikatoren ($Id_k$) der vorhergehenden sortierten Liste von Identifikatoren (LT') ist und mindestens einen Identifikator ($Id_k$) aufweisen, dessen zugeordnete Ordnungszahl (k) in vorgegebener Ordnungsrelation mit der Ordnungszahl (k), die dem ersten Identifikator ($l_1$) der vorhergehenden sortierte Liste von Identifikatoren (LT') zugeordnet ist, ist, Entfernen (140) dieses Identifikators ($l_1$) der vorhergehenden Liste von Identifikatoren (LT') zum Erhalten einer nachfolgenden sortierten Liste von Identifikatoren und Verringern der ersten Variablen (j) um Eins;
   - Kodieren (145) der Liste von Identifikatoren mittels eines Codes (C) entsprechend der Summe von allen erhaltenden elementaren Codes ($C_j$).

2. Verfahren (100) gemäß Anspruch 1, dadurch charakterisiert, dass eine erste Ordnungszahl in vorgegebener Ordnungsrelation mit einer zweiten Ordnungszahl ist, wenn die erste Ordnungszahl echt größer als die zweite Ordnungszahl ist.

3. Verfahren (100) gemäß Anspruch 2, dadurch charakterisiert, dass sie außerdem die folgenden Schritte aufweist:

   - Definieren (120) eines Zwischen-Maximalwerts (max) gleich der Gesamtzahl (N) von Identifikatoren ($Id_k$) in der globalen Liste (LG) von Identifikatoren;
   - Variieren (130) einer zweiten ganzzahligen Variablen (i) zwischen der Ordnungszahl ($k_1$) des ersten Identifikators ($l_1$) der vorhergehenden sortierten Liste von Identifikatoren (LT') und dem Zwischen-Maximalwert (max), verringert um Eins;
   - für jeden Wert der zweiten Variablen (i), Berechnen der Anzahl von Teilmengen mit einer Anzahl von Elementen gleich der ersten Variablen (j) verringert um Eins, in einer Menge mit einer Anzahl von Elementen gleich der zweiten Variablen (i);
   - Berechnen (130) eines elementaren Codes ($C_j$) entsprechend dem ersten Identifikator ($l_1$) der vorhergehenden sortierten Liste (LT') als die Summe der Anzahl von Teilmengen, d.h.

$$C_j = \sum_{i=k_1}^{\max-1} c_i^{j-1}$$

wobei

$k_1$ die dem ersten Identifikator zugeordnete Zahl bezeichnet,
i die zweite Variable bezeichnet,
max den Maximalwert bezeichnet,

$c_i^{j-1}$ die Anzahl von Teilmengen bezeichnet und

$C_j$ den elementaren Code bezeichnet.

- Setzen (140) des Zwischen-Maximalwerts (max) gleich der Zahl ($k_1$), die dem ersten Identifikator ($I_1$) zugeordnet ist, verringert um Eins und
- Ausführen der Schritte zum Kodieren des ersten Identifikators der vorhergehenden sortierten Liste von Identifikatoren mittels eines elementaren Codes, zum Entfernen und zum Verringern solange die erste Variable (j) größer als Null ist (125).

4. Computerprogrammprodukt aufweisend Software-Instruktionen die, wenn sie von einem Rechner ausgeführt werden, das Verfahren zum Kodieren (100) gemäß einem der vorhergehenden Ansprüche durchführen.

5. Sender (E) für ein Computernetzwerk (10), wobei das Computernetzwerk (10) mindestens einen Empfänger ($R_1$, ..., $R_N$) aufweist,
wobei der oder jeder Sender und der oder jeder Empfänger dieselbe globale Liste (LG) von unterschiedlichen Identifikatoren ($Id_k$) aufweisen, wobei jeder Identifikator ($Id_k$) eine technische Eigenschaft hat,
wobei der Sender (E) geeignet ist, ein Paket (12) mit Daten an einen oder mehrere unterschiedliche Empfänger ($R_1$, ..., $R_N$) zu senden,
wobei jedes Paket mit Daten (12) mindestens einen Code (C) aufweist, der einer kodierten Liste von Identifikatoren (L) entspricht, in der jeder Identifikator ($Id_k$) höchstens nur einmal vorhanden ist,
dadurch charakterisiert, dass er ein Modul zum Kodieren (46) aufweist geeignet zum:

- Zuordnen (105), zu jedem Identifikator ($Id_k$) eine Ordnungszahl (k) zwischen 1 und der Gesamtzahl (N) von Identifikatoren ($Id_k$) in der globalen Liste von Identifikatoren (LG), wobei die Zahl (k) für unterschiedliche Identifikatoren ($Id_k$) unterschiedlich ist;
- Anordnen der Liste von Identifikatoren (L) gemäß einer vorgegebenen strengen Ordnungsrelation, wobei der Ordnungszahl (k) gefolgt wird, die jedem Identifikator ($Id_k$) zugeordnet ist, um eine sortierte Liste (LT) von Identifikatoren zu erhalten;
- Definieren (120) einer ersten ganzzahligen Variablen (j) gleich der Anzahl (P) von Identifikatoren in der zu sendenden Liste von Identifikatoren (L), Initialisieren einer vorhergehenden sortierten Liste von Identifikatoren (LT') durch die sortierte Liste von Identifikatoren (LT);
- Kodieren (130, 135) des ersten Identifikators ($I_1$) der vorhergehenden sortierten Liste von Identifikatoren (LT') mittels eines elementaren Codes ($C_j$) entsprechend der Anzahl von Teilmengen der globalen Liste (LG) mit einer Anzahl von Elementen, die gleich der Anzahl von Identifikatoren ($Id_k$) der vorhergehenden sortierten Liste von Identifikatoren (LT') ist und mindestens einen Identifikator ($Id_k$) aufweisen, dessen zugeordnete Ordnungszahl (k) in vorgegebener Ordnungsrelation mit der Ordnungszahl (k), die dem ersten Identifikator ($I_1$) der vorhergehenden sortierte Liste von Identifikatoren (LT') zugeordnet ist, ist, Entfernen (140) dieses Identifikators ($I_1$) der vorhergehenden Liste von Identifikatoren (LT') zum Erhalten einer nachfolgenden sortierten Liste von Identifikatoren und Verringern der ersten Variablen (j) um Eins;
- Kodieren (145) der Liste von Identifikatoren mittels eines Codes (C) entsprechend der Summe von allen erhaltenden elementaren Codes ($C_j$).

6. Verfahren (200) zum Dekodieren einer Liste von Identifikatoren (L), verwendbar in einem Computernetzwerk (10), wobei das Computernetzwerk (10) mindestens einen Sender (R) und mindestens einen Empfänger ($R_1$, ..., $R_N$) aufweist,
wobei der oder jeder Sender und der oder jeder Empfänger dieselbe globale Liste (LG) von unterschiedlichen

Identifikatoren ($Id_k$) aufweist, wobei jeder Identifikator ($Id_k$) eine technische Eigenschaft hat,
wobei der oder jeder Sender (E) geeignet ist, ein Paket (12) mit Daten an einen oder mehrere unterschiedliche Empfänger ($R_1$, ..., $R_N$) zu senden,
wobei jedes Paket mit Daten (12) mindestens einen Code (C) aufweist, der einer kodierten Liste von Identifikatoren (L) entspricht, in der jeder Identifikator ($Id_k$) höchstens nur einmal vorhanden ist,
dadurch charakterisiert, dass das Verfahren (200) die folgenden Schritte aufweist:

- Zuordnen (205), zu jedem Identifikator ($Id_k$) eine Ordnungszahl (k) zwischen 1 und der Anzahl (N) von Identifikatoren ($Id_k$) in der globalen Liste von Identifikatoren (LG), wobei die Zahl (k) für unterschiedliche Identifikatoren ($Id_k$) unterschiedlich ist;
- Empfangen (210) einer Zahl (P) entsprechend der Anzahl von Identifikatoren ($Id_k$) in der zu dekodierenden Liste von Identifikatoren (L) und eines Codes (C) entsprechend dieser Liste von Identifikatoren;
- Definieren (215) eines Zwischen-Maximalwerts (max) gleich der Gesamtzahl (N) von Empfängern und einer ersten ganzzahligen Variablen (j) gleich der Anzahl von Identifikatoren (P) in der zu dekodierenden Liste von Identifikatoren (L);
- Berechnen (220) der Anzahl (F) von Teilmengen mit einer Anzahl von Elementen gleich der ersten Variablen (j) verringert um Eins in einer Menge mit einer Anzahl von Elementen gleich dem Zwischen-Maximalwert (max) verringert um Eins;
- falls der Wert des Codes kleiner ist als die Anzahl (F) von Teilmengen, Hinzufügen (230) in der Liste von Identifikatoren (L) den Identifikator ($Id_k$) mit einer Ordnungszahl (k) gleich dem Zwischen-Maximalwert (max) und Verringern des Zwischen-Maximalwerts (max) und der ersten Variablen (j) um Eins;
- falls der Wert des Codes größer oder gleich der Anzahl (F) von Teilmengen ist, Verringern (240) des Zwischen-Maximalwerts (max) um Eins und Berechnen eines neuen Werts des Codes gleich dem Unterschied zwischen dem aktuellen Wert des Codes (C) und der Anzahl (F) von Teilmengen.

7. Computerprogrammprodukt aufweisend Software-Instruktionen die, wenn sie von einem Rechner ausgeführt werden, das Verfahren (200) zum Dekodieren gemäß Anspruch 6 durchführen.

8. Empfänger ($R_1$, ..., $R_N$) für ein Computernetzwerk (10), wobei das Computernetzwerk (10) mindestens einen Sender (R) aufweist,
wobei der oder jeder Sender und der Empfänger dieselbe globale Liste (LG) von unterschiedlichen Identifikatoren ($Id_k$) aufweisen, wobei jeder Identifikator ($Id_k$) eine technische Eigenschaft hat,
wobei der oder jeder Sender (E) geeignet ist, ein Paket (12) mit Daten an einen oder mehrere unterschiedliche Empfänger ($R_1$, ..., $R_N$) zu senden,
wobei jedes Paket mit Daten (12) mindestens einen Code (C) aufweist, der einer kodierten Liste von Identifikatoren (L) entspricht, in der jeder Identifikator ($Id_k$) höchstens nur einmal vorhanden ist,
dadurch charakterisiert, dass das er ein Modul (56) zum Dekodieren aufweist geeignet zum:

- Zuordnen (205), zu jedem Identifikator ($Id_k$) eine Ordnungszahl (k) zwischen 1 und der Anzahl (N) von Identifikatoren ($Id_k$) in der globalen Liste von Identifikatoren (LG), wobei die Zahl (k) für unterschiedliche Identifikatoren ($Id_k$) unterschiedlich ist;
- Empfangen (210) einer Zahl (P) entsprechend der Anzahl von Identifikatoren ($Id_k$) in der zu dekodierenden Liste von Identifikatoren (L) und eines Codes (C) entsprechend dieser Liste von Identifikatoren;
- Definieren (215) eines Zwischen-Maximalwerts (max) gleich der Gesamtzahl (N) von Empfängern und einer ersten ganzzahligen Variablen (j) gleich der Anzahl von Identifikatoren (P) in der zu dekodierenden Liste von Identifikatoren (L);
- Berechnen (220) der Anzahl (F) von Teilmengen mit einer Anzahl von Elementen gleich der ersten Variablen (j) verringert um Eins in einer Menge mit einer Anzahl von Elementen gleich dem Zwischen-Maximalwert (max) verringert um Eins;
- falls der Wert des Codes kleiner ist als die Anzahl (F) von Teilmengen, Hinzufügen (230) in der Liste von Identifikatoren (L) den Identifikator ($Id_k$) mit einer Ordnungszahl (k) gleich dem Zwischen-Maximalwert (max) und Verringern des Zwischen-Maximalwerts (max) und der ersten Variablen (j) um Eins;
- falls der Wert des Codes größer oder gleich der Anzahl (F) von Teilmengen ist, Verringern (240) des Zwischen-Maximalwerts (max) um Eins und Berechnen eines neuen Werts des Codes gleich dem Unterschied zwischen dem aktuellen Wert des Codes (C) und der Anzahl (F) von Teilmengen.

**Claims**

1. A method (100) for encoding a list of identifiers (*L*) which may be used in a computer network (10), the computer network (10) including at least one transmitter (E) and at least one receiver ($R_1$, ..., $R_N$),

   said or each transmitter and said or reach receiver including a same global list (*LG*) of different identifiers ($Id_k$), each identifier ($Id_k$) having a technical characteristic,

   said or each transmitter (E) being able to transmit a data packet (12) intended for one or several different receivers ($R_1$, ..., $R_N$),

   each data packet (12) including at least one code (*C*) corresponding to a coded list of identifiers (*L*), wherein each identifier ($Id_k$) is only present at most once,

   **characterized in that** the encoding method (100) comprises the following steps:

   - associating (105) with each identifier ($Id_k$) an ordinal number (*k*) comprised between one and the total number (*N*) of identifiers ($Id_k$) in the global list of identifiers (*LG*), the number (*k*) being different for different identifiers ($Id_k$);
   - ordering according to a predetermined strict order relationship, the identifier list (*L*) according to the ordinal number (*k*) associated with each identifier ($Id_k$) in order to obtain a sorted list (*LT*) of identifiers;
   - defining (120) a first integer variable (*j*) equal to the number (*P*) of identifiers in the list of identifiers (*L*) to be transmitted, initializing a previous sorted list of identifiers (*LT'*) with the sorted list of identifiers (*LT*);
   - coding (130, 135) the first identifier ($I_1$) of the previous sorted list of identifiers (*LT'*) with an elementary code ($C_j$) corresponding to the number of sub-sets of the global list of identifiers (*LG*) of cardinal equal to the number of identifiers ($Id_k$) of the previous sorted list of identifiers (*LT'*) and including at least one identifier ($Id_k$) for which the associated ordinal number (*k*) is in a predetermined strict order relationship with the ordinal number (*k*) associated with the first identifier ($I_1$) of the previous sorted list of identifiers (*LT'*), removing (140) this identifier ($I_1$) from the previous sorted list of identifiers (*LT'*) in order to obtain a following sorted list of identifiers, and decrementing by one the first variable (*j*);
   - coding (145) the list of identifiers with a code (*C*) corresponding to the sum of all the obtained elementary codes ($C_j$).

2. The method (100) according to claim 1, **characterized in that** a first ordinal number is in a predetermined strict order relationship with a second ordinal number when the first ordinal number is strictly greater than the second ordinal number.

3. The method (100) according to claim 2, **characterized in that** it further includes the following steps:

   - defining (120) an intermediate maximum value (*max*) equal to the total number (*N*) of identifiers ($Id_k$) in the global list (*LG*) of identifiers;
   - varying (130) a second integer variable (*i*) between the ordinal number ($k_1$) of the first identifier ($I_1$) of the previous sorted list of identifiers (*LT'*) and the intermediate maximum value (*max*) decremented by one;
   - for each value of the second variable (*i*), computing the number of sub-sets of cardinal equal to the first variable (*j*) decremented by one, in a set with a cardinal equal to the second variable (*i*);
   - computing (130) an elementary code ($C_j$) corresponding to the first identifier ($I_1$) of the previous sorted list of identifiers (*LT'*) as the sum of said numbers of sub-sets, i.e.:

   $$C_j = \sum_{i=k_1}^{max-1} C_i^{j-1}$$

   with

   $k_1$ referring to the number associated with said first identifier,
   *i* referring to said second variable,
   *max* referring to said maximum value,

   $C_i^{j-1}$ referring to said number of sub-sets, and
   $C_j$ referring to said elementary code,

   - setting (140) the intermediate maximum value *max* equal to the number ($k_1$) associated with the first identifier

($I_1$) decremented by one; and
- execute the steps of coding the first identifier of the previous sorted list of identifiers with an elementary code, removing and decrementing as long as the first variable ($j$) is greater than zero (125).

4. The computer program product including software instructions which when they are applied by a computer, apply the encoding method (100) according to any of the preceding claims.

5. A transmitter (E) for a computer network (10), the computer network (10) including at least one receiver ($R_1$, ..., $R_N$), the transmitter and said or each receiver including a same global list ($LG$) of different identifiers ($Id_k$), each identifier ($Id_k$) having a technical characteristic,
   the transmitter (E) being able to transmit a data packet (12) intended for one or several different receivers ($R_1$, ..., $R_N$), each data packet (12) including at least one code ($C$) corresponding to a coded list of identifiers ($L$), wherein each identifier ($Id_k$) is present at most only once,
   **characterized in that** it includes an encoding module (46) capable of:

   - associating (105) with each identifier ($Id_k$) an ordinal number ($k$) comprised between one and the total number ($N$) of identifiers ($Id_k$) in the global list of identifiers ($LG$), the number ($k$) being different for different identifiers ($Id_k$);
   - ordering according to a predetermined strict order relationship, the list of identifiers ($L$) according to the ordinal number ($k$) associated with each identifier ($Id_k$) in order to obtain a sorted list ($LT$) of identifiers;
   - defining (120) a first integer variable ($j$) equal to the number ($P$) of identifiers in the list of identifiers ($L$) to be transmitted, initializing a previous sorted list of identifiers ($LT'$) with the sorted list of identifiers ($LT$);
   - coding (130, 135) the first identifier ($I_1$) of the previous sorted list of identifiers ($LT'$) with an elementary code ($C_j$) corresponding to the number of sub-sets of the global list of identifiers ($LG$) of a cardinal equal to the number of identifiers ($Id_k$) of the previous sorted list of identifiers ($LT'$) and including at least one identifier ($Id_k$) for which the associated ordinal number ($k$) is in a predetermined strict order relationship with the ordinal number ($k$) associated with the first identifier ($I_1$) of the previous sorted list of identifiers ($LT'$), removing (140) this identifier ($I_1$) from the previous sorted list of identifiers ($LT'$) in order to obtain a following sorted list of identifiers, and decrementing by one the first variable ($j$);
   - coding (145) the list of identifiers with a code ($C$) corresponding to the sum of all the obtained elementary codes ($C_j$).

6. A method (200) for decoding a list of identifiers ($L$) which may be used in a computer network (10), the computer network (10) including at least one transmitter (E) and at least one receiver ($R_1$, ..., $R_N$), said or each transmitter and said or each receiver including a same global list ($LG$) of different identifiers ($Id_k$), each identifier ($Id_k$) having a technical characteristic,
   said or each transmitter (E) being able to transmit a data packet (12) intended for one or several different receivers ($R_1$, ..., $R_N$),
   each data packet (12) including at least one code ($C$) corresponding to a coded list of identifiers ($L$), wherein each identifier ($Id_k$) is at most only present once,
   **characterized in that** the method (200) comprises the following steps:

   - associating (205) with each identifier ($Id_k$) an ordinal number ($k$) comprised between one and the number ($N$) of identifiers in the global list of identifiers ($LG$), the number (k) being different for different identifiers ($Id_k$);
   - receiving (210) a number ($P$) corresponding to the number of identifiers ($Id_k$) in the list of identifiers ($L$) to be decoded, and a code ($C$) corresponding to this list of identifiers;
   - defining (215) an intermediate maximum value ($max$) equal to the total number of receivers ($N$) and a first integer variable ($j$) equal to the number of identifiers ($P$) in the list of identifiers ($L$) to be decoded;
   - computing (220) the number ($F$) of sub-sets of cardinal equal to the first variable ($j$) decremented by one, in a set of cardinal equal to the intermediate maximum value ($max$) decremented by one;
   - if the value of the code is less than said number ($F$) of sub-sets, adding (230) in the list of identifiers ($L$) the identifier ($Id_k$) with an ordinal number ($k$) equal to the intermediate maximum value ($max$), decrementing the intermediate maximum value ($max$) and the first variable ($j$) by one;
   - if the value of the code is greater than or equal to said number ($F$) of sub-sets, decrementing (240) the intermediate maximum value ($max$) by one and computing a new value of the code equal to the difference between the present value of the code ($C$) and said number ($F$) of sub-sets.

7. A computer program product, including a software instructions which when they are applied by a computer, apply the decoding method (200) according to claim 6.

**8.** A receiver (R$_1$, ..., R$_N$) for a computer network (10), the computer network (10) including at least one transmitter (E), said or each transmitter and the receiver including a same global list (*LG*) of different identifiers (*Id$_k$*), each identifier (*Id$_k$*) having a technical characteristic,
said or each transmitter (E) being able to transmit a data packet (12) intended for one or several different receivers (R$_1$, ..., R$_N$),
each data packet (12) including at least one code (*C*) corresponding to a coded list of identifiers (*L*), wherein each identifier (*Id$_k$*) is present at most only once,
**characterized in that** it includes a decoding module (56) capable of:

- associating (205) with each identifier (*Id$_k$*) an ordinal number (*k*) comprised between one and the number (*N*) of identifiers in the global list of identifiers (*LG*), the number (*k*) being different for different identifiers (*Id$_k$*);
- receiving (210) a number (*P*) corresponding to the number of identifiers (*Id$_k$*) in the list of identifiers (*L*) to be decoded, and a code (*C*) corresponding to this list of identifiers;
- defining (215) an intermediate maximum value (*max*) equal to the total number of receivers (*N*) and a first integer variable (*j*) equal to the number of identifiers (*P*) in the list of identifiers (*L*) to be decoded;
- computing (220) the number (*F*) of sub-sets of cardinal equal to the first variable (*j*) decremented by one, in a set with a cardinal equal to the intermediate maximum value (*max*) decremented by one;
- if the value of the code is less than said number (*F*) of sub-sets, adding (230) in the list of identifiers (*L*) the identifier (*Id$_k$*) with an ordinal number (*k*) equal to the intermediate maximum value (*max*), decrementing the intermediate maximum value (*max*) and the first variable (*j*) by one;
- if the value of the code is greater than or equal to said number (*F*) of sub-sets, decrementing (240) the intermediate maximum value (*max*) by one and computing a new value of the code equal to the difference between the present value of the code (*C*) and said number (*F*) of sub-sets.

## FIG.1

## FIG.2

## FIG.3

## FIG.4

| Code | 1° identifiant | 2° identifiant | 3° identifiant |
|---|---|---|---|
| 0 | 7 | 6 | 5 |
| 1 | 7 | 6 | 4 |
| 2 | 7 | 6 | 3 |
| 3 | 7 | 6 | 2 |
| 4 | 7 | 6 | 1 |
| 5 | 7 | 5 | 4 |
| 6 | 7 | 5 | 3 |
| 7 | 7 | 5 | 2 |
| 8 | 7 | 5 | 1 |
| 9 | 7 | 4 | 3 |
| 10 | 7 | 4 | 2 |
| 11 | 7 | 4 | 1 |
| 12 | 7 | 3 | 2 |
| 13 | 7 | 3 | 1 |
| 14 | 7 | 2 | 1 |
| 15 | 6 | 5 | 4 |
| 16 | 6 | 5 | 3 |
| 17 | 6 | 5 | 2 |
| 18 | 6 | 5 | 1 |
| 19 | 6 | 4 | 3 |
| 20 | 6 | 4 | 2 |
| 21 | 6 | 4 | 1 |
| 22 | 6 | 3 | 2 |
| 23 | 6 | 3 | 1 |
| 24 | 6 | 2 | 1 |
| 25 | 5 | 4 | 3 |
| 26 | 5 | 4 | 2 |
| 27 | 5 | 4 | 1 |
| 28 | 5 | 3 | 2 |
| 29 | 5 | 3 | 1 |
| 30 | 5 | 2 | 1 |
| 31 | 4 | 3 | 2 |
| 32 | 4 | 3 | 1 |
| 33 | 4 | 2 | 1 |
| 34 | 3 | 2 | 1 |

## FIG.5

EP 2 887 622 B1

```
   105                      110                        115
┌ ─ ─ ─ ─ ─ ─ ─ ┐   ┌──────────────┐   ┌──────────────────────────┐
│   Associer k    │   │  Recevoir la  │   │  Trier la liste L pour obtenir │
│  à chaque Id k  │───│ liste d'identifiants L │───│ une liste triée LT= { I₁ ,I₂ ,...,I_p } │
└ ─ ─ ─ ─ ─ ─ ─ ┘   └──────────────┘   └──────────────────────────┘
```

Associer k à chaque $Id_k$

Recevoir la liste d'identifiants L

Trier la liste L pour obtenir une liste triée $LT = \{ l_1, l_2, ..., l_p \}$

$j = P$, max $= N$, C $= 0$   — 120

125 — j > 0 ?

non

oui

145

$$C = \sum_{j-1}^{P} C_j$$

130

Pour chaque $i = k_1, ..., max - 1$

$$C_j = C_j + C_i^{j-1}$$

max $= k_1 - 1$   — 135

$LT = LT \setminus l_1 = \{ l_1, ... l_{j-1} \}, j = j-1$   — 140

Transmettre le code C

150

100

**FIG.6**

**FIG.7**

```
┌ ─ ─ ─ ─ ─ ─ ─ ─ ─ ─ ─ ┐
    Recevoir un nombre k
    pour chaque Id_k           ───  205
└ ─ ─ ─ ─ ─ ─ ─ ─ ─ ─ ─ ┘
```

200

Recevoir le nombre
P et le code C          ── 210

$max = N, j = P, L = \{ \varnothing \}$          ── 215

$F = C^{j-1}_{max-1}$          ── 220

225   $C \geq F ?$   non

oui

$L = L \cup \{ Id_{max} \}$
$max = max - 1$
$j = j - 1$          ── 230

$max = max - 1$
$C = C - F$          240

235   $j > 0 ?$   non   →   Transmettre L   ── 245

oui

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 0246938 A2